Europäisches Patentamt

European Patent Office

Office européen des brevets

(19)

(11) Publication number: **0 316 149**
**A2**

(12) **EUROPEAN PATENT APPLICATION**

(21) Application number: 88310536.3

(22) Date of filing: 09.11.88

(51) Int. Cl.4: **H03K 17/693 , H03K 17/687**

(30) Priority: **12.11.87 GB 8726524**

(43) Date of publication of application:
**17.05.89 Bulletin 89/20**

(84) Designated Contracting States:
**DE FR GB IT NL SE**

(71) Applicant: **LUCAS INDUSTRIES public limited company**
**Great King Street**
**Birmingham, B19 2XF West Midlands(GB)**

(72) Inventor: **Samuroff, Steven Richard**
**106 Twyford Road**
**West Harrow Middlesex HA2 OSN(GB)**

(74) Representative: **Gibson, Stewart Harry et al**
**URQUHART-DYKES & LORD Business**
**Technology Centre Senghennydd Road**
**Cardiff CF2 4AY South Wales(GB)**

(54) Electronic switch arrangement.

(57) An electronic switching arrangement for use in e.g. a frequency-hopping radar system, for selectively switching one of several oscillators to an output. A signal input (IN) is connected to a signal output (OUT) by a series signal path which includes a field-effect transistor (FET 1), another field-effect transistor (FET 2) being connected in shunt on the signal path, and respective switches (T1,T2) controlling the field-effect transistors (FET 1, FET 2) to turn one on whilst the other is turned off and vice versa. Preferably the arrangement includes a plurality of stages (S1,S2,S3) each comprising the series and shunt FET'S and their controlling switches (T1,T2). The switching arrangement provides a very high degree of isolation between its input and output when in the "off" condition.

EP 0 316 149 A2

## ELECTRONIC SWITCH ARRANGEMENT

This invention relates to an electronic switch arrangement for selectively coupling an input to or isolating it from an output.

There are some applications which require that an electronic switch provides a very high degree of isolation of its input from its output when in the "off" condition. One such application is in the field of frequency-hopping systems e.g. frequency-hopping radar systems, in which a number of continuously-running crystal oscillators are provided with respective electronic switches for coupling the outputs of the different oscillators to the utilisation circuits at selected intervals. Generally the selected oscillator output is applied to a frequency multiplying circuit and should even a small fraction of any non-selected oscillator output pass to this multiplying circuit, the multiplication process has the effect of amplifying the unwanted signal relative to the wanted signal, such that the signal-to-spurious ratio is considerably degraded.

With frequency-hopping radar for example, a signal-to-spurious (unwanted signal) ratio of the order of 100db is required. It is not possible to turn off the non-selected oscillators in order to obtain the required isolation, because once a crystal oscillator is turned on it takes a period of the order of 2 milliseconds to settle to its running condition, whilst for frequency-hopping radar for example a much shorter settling time (of the order of 200 nanoseconds) would be necessary. Oscillators with a phase-lock may be used, but it is difficult to provide for switching quickly enough and maintain the locked condition.

In frequency-hopping systems having continuously running crystal oscillators, diode switching arrangements have been employed and provided adequate levels of isolation in the "off" condition of the switch. However, it has been necessary for these to employ both positive and negative supply rails as well as ground thus adding to their complexity. Also, the overall switch modules have been bulky.

We have now devised an electronic switching arrangement which overcomes these difficulties and provides a very high degree of isolation between its input and output when in the "off" condition.

In accordance with this invention, there is provided an electronic switching arrangement comprising a signal input and a signal output, a signal path connecting the input and output, a first field-effect transistor connected in shunt with respect to the signal path, a second field-effect transistor connected in series on the signal path, and respective switches for controlling the field-effect transistors and arranged to turn one field-effect transistor on when the other is turned off and vice versa.

Thus in the "on" condition of this electronic switching arrangement, the first or shunt field-effect transistor is non-conductive and the second or series field effect transistor is conductive. Conversely, in the "off" condition of the switching arrangement, the shunt FET is conductive for applying the input signal to a terminal load and the series FET is non-conductive. The non-conductive series FET provides a high degree of isolation of the signal output from the input. Further, any leakage of signal from the conductive shunt FET to the signal output via the gate of the series FET is greatly diminished by the use of separate switches for controlling the two FET'S.

In a preferred embodiment, respective bipolar transistors form the switches for controlling the two FET'S, the two bipolar transistors being of opposite type and in turn both controlled by a further switch to which a switching signal is applied.

Also in a preferred embodiment, the electronic switching arrangement comprises a plurality of stages (e.g. three stages) connected in series between the signal input and the signal output, each stage comprising a shunt FET and a series FET and respective switches for controlling them.

An embodiment of this invention will now be described by way of example only and with reference to the accompanying drawings, in which:

FIGURE 1 is a block diagram of a frequency-hopping radar system incorporating a number of crystal oscillators and respective electronic switching modules; and

FIGURE 2 is a circuit diagram of an electronic switching module in accordance with this invention.

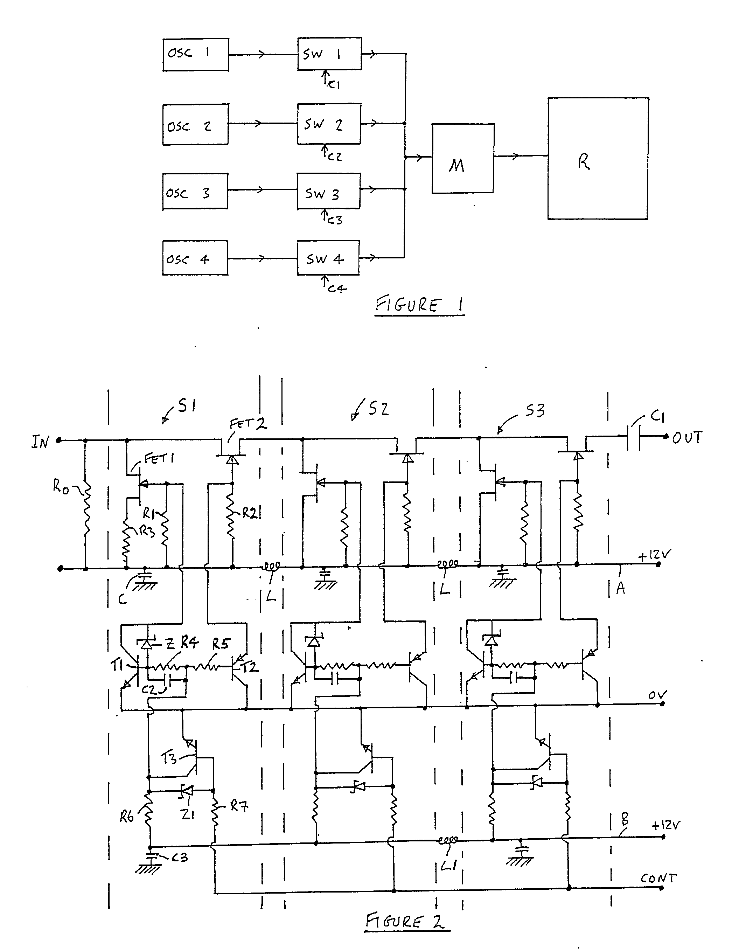

Referring to Figure 1, four VHF crystal oscillators OSC 1 - OSC 4 run continuously at their different frequencies. Their outputs are applied to respective switching modules SW1 - SW4, having their outputs jointly connected to a frequency multiplier M, the output of which is connected to the utilisation circuitry R of the frequency-hopping radar system. Control inputs C1 -C4 of the switching modules provide for switching the outputs of the different oscillators to the circuitry R at intervals in accordance with known principles.

Referring to Figure 2, there is shown the circuit of an electronic switching arrangement used for each of the modules SW1 - SW4 of Figure 1. This switching arrangement comprises a signal input IN for connection to the respective oscillator output, and a signal output OUT for connection to the input of the frequency multiplier M. Three switching stages S1 - S3 are connected in series between the signal input IN and the signal output OUT, each stage comprising a shunt field-effect transistor FET 1 and a series field-effect transistor FET 2. In the first stage S1, the shunt field-effect transistor FET 1 has its source-drain path connected through a series resistor R3 to a +12V supply rail A: in the following stages the source of the shunt field-effect transistor is connected directly to the +12V rail. The gates off the respective shunt and series FET'S are connected to supply rail A through resistors R1, R2. In each stage, the supply rail is decoupled to ground through a capacitor C. Inductances L1,L2 are connected in series on the supply rail A between the adjacent stages SI,S2 and S2,S3 respectively. A resistor Ro is connected across the input IN to the supply rail for the purpose of impedance matching, and the output of the stage S3 is connected to the signal output OUT of the switching circuit by a coupling capacitor CI.

The two FET'S of each stage are controlled by respective switching transistors T1 and T2 having their emitter-collector paths connected between the gates of the respective FET's and a ground rail. Transistor T1 is of npn-type with its collector connected to the gate of FET 1, whilst transistor T2 is of pnp-type with its emitter connected to the gate of FET 2. The bases of transistors T1 and T2 are interconnected by resistors R4 and R5 in series. A capacitor C2 is connected across the base resistor R4 of transistor T1 and a zener diode Z is connected across the base-collector junction of this transistor to speed-up its switching.

The two transistors T1,T2 are controlled by a third transistor T3 in each stage, which in the example shown is an npn-transistor with its emitter connected to the ground rail and its collector connected through a resistor R6 to a branch B of the +12V supply rail as well as to the junction between the base resistors R4,R5 of transistors T1,T2. A zener diode ZI is connected across the base-collector junction of transistor T3 and a control input CONT is connected to the bases of the transistors T3 of the three stages through respective resistors R7. The branch B of the supply rail is decoupled to ground in each of stages S1 and S3 by a capacitor C3, and an inductance L1 is connected in branch B between stages S2 and S3.

The electronic switching arrangement is switched "on" or "off" according to whether 0 volts or +5 volts is applied to the control input CONT. Thus if 0 volts is applied to control input CONT, the transistor T3 in each stage S1 - S3 is non-conductive, holding the bases of transistors T1 and T2 high and so rendering transistor T1 conductive and transistor T2 non-conductive. In turn, with transistor T1 conductive the shunt field-effect transistor FET 1 is held non-conductive and with transistor T2 non-conductive the series field-effect transistor FET 2 conducts. The RF input from the respective oscillator therefore passes through the three stages S1 - S3 in series to the signal output OUT and to the frequency multiplier M. Conversely, if +5 volts is applied to control input CONT to render transistor T3 in each stage conductive, this holds the bases of transistors T1 and T2 low, switching off transistor T1 and switching on transistor T2, so as to render the shunt field-effect transistor FET 1 conductive and render the series field-effect FET 2 non-conductive.

In the "off" condition, each series field-effect transistor FET 2 provides a high degree of isolation and this is enhanced by having three stages S1 - S3 in series. RF signals passing through the shunt field-effect transistor FET 1 pass to ground through the capacitor C in each stage, and are inhibited from passing along the supply rail A by the interstage inductances L. The transistors T1 and T2 provide for separate control of the field-effect transistors and provide isolation between the gates of the two FET's to prevent signal leakage from the shunt FET to the series FET and hence to the signal output OUT. The transistors T1 and T2 and their associated components present considerable impedance to any leakage currents from the gate of FET 1 to the gate of FET 2. Any leakage current reaching the collector circuit of transistor T3 is decoupled to ground by capacitor C3 and inhibited from passing along the supply rail B by the inductance L1.

Referring to Figure 2, the bipolar transistor switches T1,T2 may be replaced by other switches, e.g. field-effect transistors.

The switching circuit shown in Figure 1 thus provides a very high level of isolation of the output OUT from the input IN when in the "off" condition. Moreover it will be noted that the circuit needs only one supply rail rather than twin supply rails.

## Claims

(1) An oscillator switching system comprising a plurality of oscillators and respective electronic switching arrangements for connecting the output of any selected oscillator to a utilisation circuit, characterised in that each electronic switching arrangement (SW1 - SW4) comprises a signal input (IN) and a signal output (OUT), a signal path connecting the input and output, a first field-effect transistor (FET 1) connected in shunt with respect to the signal path, a second field-effect transistor (FET2) connected in series on the signal path, and respective switches (T1,T2) for controlling the field-effect transistors and arranged to turn one field-effect transistor on when the other is turned off and vice versa.

(2) An oscillator switching system as claimed in claim 1, characterised in that each switching arrangement comprises a further switch (T3) which receives a switching signal and controls the respective switches (T1,T2) controlling the first and second field-effect transistors (FET 1, FET 2).

(3) An oscillator switching system as claimed in claim 2, characterised in that the respective switches (T1,T2) controlling the first and second field-effect transistors (FET 1, FET 2) comprise bipolar transistors.

(4) An oscillator switching system as claimed in claim 2, characterised in that the respective switches (T1,T2) controlling the first and second field-effect transistors (FET 1, FET 2) comprise third and fourth field effect transistors.

(5) An oscillator switching system as claimed in any preceding claim, characterised in that each electronic switching arrangement comprises a plurality of stages (S1,S2,S3) connected in series between the signal input (IN) and the signal output (OUT), each stage comprising a said shunt field-effect transistor (FET 1) and a said series field-effect transistor (FET 2) and respective said switches (T1,T2) for controlling them.

(6) An oscillator switching system as claimed in any preceding claim, characterised in that the shunt field-effect transistor (FET 1) connects the series signal path to a supply rail (A) which is decoupled to ground by a capacitor (C).

(7) An oscillator switching system as claimed in claim 6 appended to claim 5, characterised in that the supply rail (A) is common to each said stage (S1,S2,S3) of each electronic switching arrangement and includes a series inductance (L) between successive stages.

(8) An electronic switching arrangement comprising a signal input (IN) and a signal output (OUT), a signal path connecting the input and output, a first field-effect transistor (FET 1) connected in shunt with respect to the signal path, a second field-effect transistor (FET 2) connected in series on the signal path, and respective switches (T1,T2) for controlling the field-effect transistors and arranged to turn one field-effect transistor on when the other is turned off and vice versa.

FIGURE 1

FIGURE 2